# EUROPEAN PATENT APPLICATION

(11) **EP 2 688 367 A1**
(43) Date of publication of application: **22.01.2014**
(21) Application number: 12183968.2
(22) Date of filing: 12.09.2012
(51) Int. Cl.: H05B 33/08, F21K 99/00, H01L 25/00, H05K 1/00

(54) **Led module, tube type lamp, and luminaire**

(30) Priority: 20.07.2012 JP 2012161668
(71) Applicant: Toshiba Lighting & Technology Corporation, Yokosuka-shi Kanagawa 237-8510 (JP)
(72) Inventor: Noguchi, Akinori, Yokosuka-shi Kanagawa, 237-8510 (JP); Kamata, Masahiko, Yokosuka-shi Kanagawa, 237-8510 (JP); Ono, Tetsuya, Yokosuka-shi Kanagawa, 237-8510 (JP)
(74) Representative: Bokinge, Ole

(57) **Abstract**

According to one embodiment, an LED module includes a substrate and a connection circuit. The connection circuit includes at least two series circuits, in each of which a plurality of LEDs are connected in series. The LEDs of the series circuits different from one another are mixedly arranged along the longitudinal direction of the substrate.

## Description

### FIELD

Embodiments described herein relate generally to an LED module in which a plurality of LEDs are arranged on a substrate and a tube type lamp and a luminaire including the LED module.

### BACKGROUND

In the past, for example, in a tube type lamp in which an LED is used as a light source, an LED module including an elongated substrate and a plurality of LEDs arranged along the longitudinal direction of the substrate is used.

As a configuration of the LED module, for example, a configuration is known in which a series circuit formed by connecting a plurality of LEDs in series is provided and a plurality of the series circuits are connected in parallel.

However, the LEDs have fluctuation in a forward voltage because of differences among individuals. Therefore, even if a constant current flows to the series circuit, different voltages are applied to the individual LEDs of the series circuit. On the other hand, if the plurality of series circuits are connected in parallel, a constant voltage is applied to the individual series circuits. However, an electric current flowing to each of the series circuits is different because of the fluctuation in the forward voltage due to the differences among individual LEDs. Therefore, a difference sometimes occurs in brightness in each of the series circuits.

In the past, the plurality of LEDs are continuously arranged in each of the series circuits along the longitudinal direction of the substrate. Therefore, if a user looks at a light-emitting section of the tube type lamp, the user tends to recognize that brightness unevenness occurs in each of the series circuits.

There is provided an LED module, a tube type lamp, and a luminaire that can reduce unevenness of brightness.

### BRIEF DESCRIPTION OF THE DRAWINGS

FIG. 1 is a front view of an LED module according to a first embodiment;
FIG. 2 is a conceptual diagram of the LED module;
FIG. 3 is a front view of an LED module according to a second embodiment;
FIG. 4 is a conceptual diagram of the LED module;
FIG. 5 is a front view of an LED module according to a third embodiment;
FIG. 6 is a front view of an LED module according to a fourth embodiment;
FIGS. 7(a) and 7(b) are diagrams of an LED module according to a fifth embodiment, wherein FIG. 7(a) is a front view of the LED module and FIG. 7(b) is a front view of the LED module of a comparative example;
FIGS. 8(a) and 8(b) are diagrams of an LED module according to a sixth embodiment, wherein FIG. 8(a) is a front view of the LED module and FIG. 8(b) is a front view of the LED module of a comparative example;
FIG. 9 is a perspective view of a tube type lamp including an LED module; and
FIG. 10 is a luminaire including the tube type lamp.

### DETAILED DESCRIPTION

In general, according to one embodiment, an LED module includes a substrate and a connection circuit. The connection circuit includes at least two or more series circuits, in each of which a plurality of LEDs are connected in series. The LEDs of the series circuits different from one another are mixedly arranged along the longitudinal direction of the substrate.

With this configuration, since the LEDs of the different series circuits are mixedly arranged along the longitudinal direction of the substrate, it is possible to expect that unevenness of brightness in the entire LED module can be reduced even if a difference occurs in brightness in each of the series circuits.

Embodiments are explained with reference to the accompanying drawings.

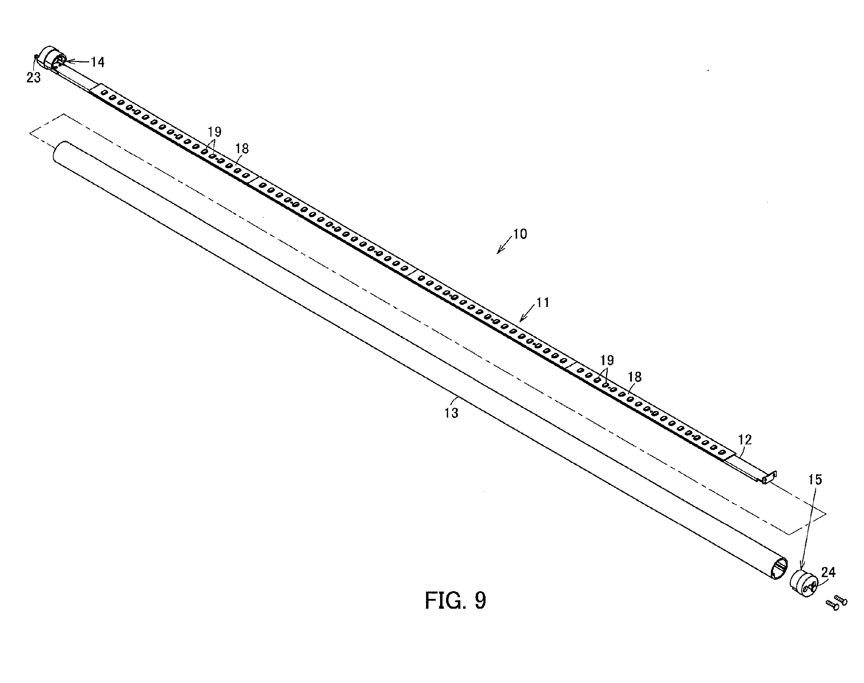

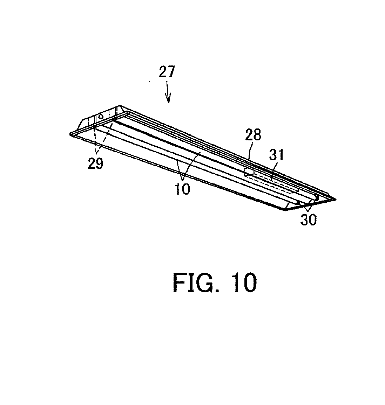

First, a tube type lamp and a luminaire including an LED module are explained with reference to FIGS. 9 and 10.

As shown in FIG. 9, a tube type lamp 10 includes an LED module 11, a supporting body 12 that supports the LED module 11, a cylindrical translucent cover 13 that houses the LED module 11 supported by the supporting body 12, a cap for power supply 14 attached to one end of the translucent cover 13, and a cap for non-power supply 15 attached to the other end of the translucent cover 13.

The LED module 11 includes a plurality of substrates 18 and a plurality of LEDs 19 mounted on the entire surfaces of the plurality of substrates 18.

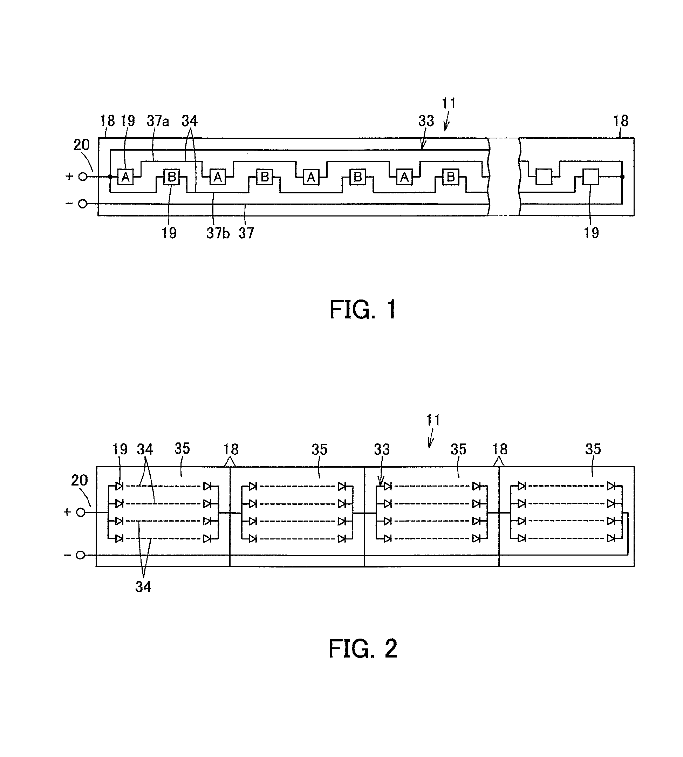

Each of the substrates 18 is formed in an elongated rectangular shape from a material such as metal, ceramics, or resin. A wiring pattern is formed on one surface of the substrate 18. The plurality of LEDs 19 are mounted on the wiring pattern. The plurality of substrates 18 are arrayed in a row along the longitudinal direction of the LED module 11. The plurality of substrates 18 are electrically connected to one another by, for example, connectors at ends of the substrates 18 opposed to each other. A connecting section 20 (see FIG. 1; e.g., a connector) connected to a positive electrode (+) and a negative electrode (-) of a direct-current power supply through the cap for power supply 14 is provided at an end of the substrate 18 located on an endmost side.

As the LED 19, for example, an LED package of a surface mounting type is used. In the LED package, LED chips are mounted on a base on which electrodes are provided. A reflector including a recess having a circular truncated cone shape in which the LED chips are housed is bonded to the base provided with an electrode. Further, translucent sealing resin including phosphors is filled in the recess.

The cap for power supply 14 includes a pair of power-supply terminals 23 electrically connected to the connecting section 20 of the substrate 18. The cap for non-power supply 15 includes a non-power-supply terminal 24.

As shown in FIG. 10, a luminaire 27 includes a luminaire main body 28 formed to be elongated. At both the ends in the longitudinal direction of the luminaire main body 28, a socket for power supply 29 and a socket for non-power supply 30, to which the cap for power supply 14 and the cap for non-power supply 15 of the tube type lamp 10 are respectively attached, are arranged. Further, in the luminaire main body 28, a lighting circuit 31 that converts commercial alternating-current power into direct-current power is arranged in the luminaire main body 28. The direct-current power converted by the lighting circuit 31 is supplied to the LED module 11 through the socket for power supply 29 and the cap for power supply 14.

The LED module 11 according to a first embodiment is explained with reference to FIGS. 1 and 2.

FIG. 2 is a conceptual diagram of the LED module 11. The LED module 11 includes the plurality of substrates 18 arrayed in a row along the longitudinal direction of the LED module 11 and electrically connected to one another. At an end of the substrate 18 located on an endmost side, the connecting section 20 connected to a positive electrode (+) and a negative electrode (-) of a direct-current power supply is provided. Connection circuit 33 that connect the plurality of LEDs 19 mounted on the plurality of substrates 18 are provided on the substrates 18.

The connection circuit 33 includes a plurality of series circuits 34 that connect the plurality of LEDs 19 in series and includes a series circuit group 35 that connects the plurality of series circuits 34 in parallel. One series circuit group 35 is arranged on each of the substrates 18. A plurality of the series circuit groups 35 are connected in series between a positive electrode (+) side and a negative electrode (-) side of the connecting section 20 (between the positive electrode (+) and the negative electrode (-) of the direct-current power supply).

FIG. 1 is a front view of the LED module 11. In FIG. 1, a part of the substrate 18 located at an endmost side and a part of the substrate 18 located on the other endmost side are shown. The substrates 18 between these substrates 18 are not shown.

A wiring pattern 37 is formed on the substrate 18. The plurality of LEDs 19 are mounted on the wiring pattern 37. The plurality of LEDs 19 of the plurality of series circuits 34 are mixedly arranged along the longitudinal direction of the substrate 18. In other words, the LEDs 19 of the series circuits 34 different from one another are mixedly arranged along the longitudinal direction of the substrate 18. Further, the LED 19 of the different series circuit 34 is arranged adjacent to each of the LEDs 19 of each of the series circuits 34. For example, as shown in FIG. 1, the plurality of LEDs 19 of the series circuits 34 indicated by A and the plurality of LEDs 19 of the series circuits 34 indicated by B are alternately arranged one by one. The LEDs 19 of the series circuits 34 indicated by A are connected in series by a wiring pattern 37a. The LEDs 19 of the series circuits 34 indicated by B are connected in series by a wiring pattern 37b. The wiring pattern 37a and the wiring pattern 37b are connected in parallel. If the series circuit group 35 includes, for example, four series circuits 34 indicated by A, B, C, and D, the plurality of LEDs 19 of the series circuits 34 indicated by C and D are mixedly arranged along the longitudinal direction of the substrate 18 to be adjacent to the plurality of the LEDs 19 of the series circuits 34 indicated by A and B mixedly arranged along the longitudinal direction of the substrate 18.

When direct-current power is supplied to the connecting section 20, all the LEDs 19 connected between the positive electrode (+) side and the negative electrode (-) side of the connecting section 20 emit light.

As explained above, since the LEDs 19 have fluctuation in a forward voltage because of differences among individuals, even if the series circuits 34 are connected in parallel and the same voltage is applied to the series circuits 34, a difference sometimes occurs among electric currents flowing to the series circuits 34. If the difference among the electric currents is large, a difference in the brightness of the series circuits 34 occurs.

For example, it is assumed that the LEDs 19 of the series circuits 34 indicated by A are darker than the LEDs 19 of the series circuits 34 indicated by B. If the LEDs 19 of the series circuits 34 indicated by A are continuously arranged in the longitudinal direction as in the past, the darkness of the LEDs 19 of the series circuits 34 indicated by A is conspicuous in the tube type lamp 10 compared with the LEDs 19 of the other series circuits 34. It is easily recognized that light unevenness occurs among the series circuits 34. On the other hand, in this embodiment, the LEDs 19 of the series circuits 34 indicated by A and the LEDs 19 of the series circuits 34 indicated by B are mixedly arranged along the longitudinal direction of the substrate 18. Therefore, the darkness of the LEDs 19 of the series circuits 34 indicated by A is inconspicuous. As a result, it is possible to make it hard to recognize that unevenness of brightness occurs among the series circuits 34.

Moreover, the LED 19 of the different series circuit 34 is arranged adjacent to each of the LEDs 19 of each of the series circuits 34. In other words, the LEDs 19 of the series circuits 34 indicated by A and the LEDs 19 of the series circuits 34 indicated by B are alternately arranged one by one along the longitudinal direction of the substrate 18. Therefore, it is possible to more surely make it hard to recognize that unevenness of brightness occurs among the series circuits 34.

In this way, in the LED module 11, the LEDs 19 of the different series circuits 34 are mixedly arranged along the longitudinal direction of the substrate 18. Therefore, even if a difference occurs in the brightness of the LEDs 19 among the series circuits 34, it is possible to reduce unevenness of the brightness in the entire LED module 11. As a result, it is possible to uniformalize the brightness in the longitudinal direction of the LED module 11.

The plurality of series circuit groups 35 are connected in series. Further, the LEDs 19 of the plurality of series circuits 34 are mixedly arranged along the longitudinal direction of the substrate 18 in each of the series circuit groups 35. Therefore, it is possible to simplify a wiring structure.

Moreover, each of the series circuit groups 35 is provided in each of the plurality of substrates 18. Therefore, it is possible to simplify the wiring structure.

If the LEDs 19 of the plurality of series circuits 34 are mixedly arranged along the longitudinal direction of the substrate 18, for example, the LEDs 19 of the series circuits 34 indicated by A and the LEDs 19 of the series circuits 34 indicated by B may be alternately arranged by a plural number (e.g., two, three, or four) along the longitudinal direction of the substrate 18.

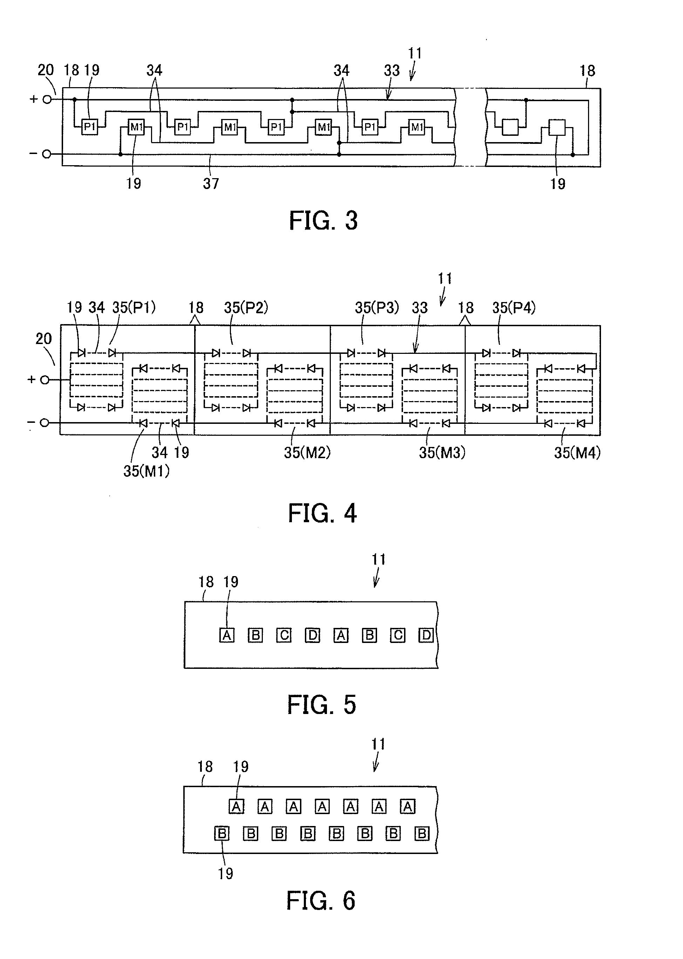

The LED module 11 according to a second embodiment is explained with reference to FIGS. 3 and 4. Explanation of components and action and effects same as those in the first embodiment is omitted.

FIG. 4 is a conceptual diagram of the LED module 11. The plurality of series circuit groups 35 are connected in series between the positive electrode (+) side and the negative electrode (-) side of the connecting section 20 (between the positive electrode (+) and the negative electrode (-) of the direct-current power supply). One series circuit group 35 close to the positive electrode (+) side of the connecting section 20 and one series circuit group 35 close to the negative electrode (-) side of the connecting section 20 are arranged on each of the substrates 18. Specifically, for example, when the series circuit groups 35 are indicated by P1, P2, P3, and P4 in order from one closest to the positive electrode (+) side of the connecting section 20 and the series circuit groups 35 are indicated by M1, M2, M3, and M4 in order from one closest to the negative electrode (-) side of the connecting section 20, the series circuit groups 35 indicated by P1 and M1, the series circuit groups 35 indicated by P2 and M2, the series circuit groups 35 indicated by P3 and M3, and the series circuit groups 35 indicated by P4 and M4 are arranged in order from the substrate 18 on the connecting section 20 side.

FIG. 3 is a front view of the LED module 11. In FIG. 3, a part of the substrate 18 located at an endmost side and a part of the substrate 18 located on the other endmost side are shown. The substrates 18 between these substrates 18 are not shown.

The connection circuit 33 includes the plurality of series circuit groups 35 in which the plurality of series circuits 34 are connected in parallel. The plurality of series circuit groups 35 are connected in series between the positive electrode (+) and the negative electrode (-) of the direct-current power supply. The LEDs 19 of the plurality of series circuits 34 are mixedly arranged along the longitudinal direction of the substrates 18 in the series circuit group 35 close to the positive electrode (+) side of the connecting section 20 and the series circuit group 35 close to the negative electrode (-) side of the connecting section 20. For example, as shown in FIG. 3, the LEDs 19 of the series circuits 34 indicated by P1 and the LEDs 19 of the series circuits 34 indicated by M1 are alternately arranged one by one.

In this embodiment, as in the first embodiment, in the LED module 11, the LEDs 19 of the plurality of series circuits 34 are mixedly arranged along the longitudinal direction of the substrate 18. Therefore, even if a difference occurs in the brightness among the series circuits 34, it is possible to reduce unevenness of the brightness in the entire LED module 11. As a result, it is possible to uniformalize the brightness in the longitudinal direction of the LED module 11.

Moreover, the plurality of series circuit groups 35 are connected in series between the positive electrode (+) and the negative electrode (-) of the direct-current power supply. Further, the LED 19 of the series circuit group 35 close to the positive electrode (+) side of the connecting section 20 and the LED 19 of the series circuit group 35 close to the negative electrode (-) side of the connecting section 20 are mixedly arranged along the longitudinal direction of the substrates 18. Therefore, it is possible to simplify a wiring structure.

If the LEDs 19 of the plurality of series circuits 34 are mixedly arranged along the longitudinal direction of the substrate 18, for example, the LEDs 19 of the series circuit groups 35 indicated by P1 and the LEDs 19 of the series circuit groups 35 indicated by M1 may be alternately arranged by a plural number (e.g., two, three, or four) along the longitudinal direction of the substrate 18.

The LED module 11 according to a third embodiment is shown in FIG. 5. Explanation of components and action and effects same as those in the embodiments explained above is omitted.

If the series circuit group 35 includes, for example, four series circuits 34 indicated by A, B, C, and D, the LEDs 19 of the series circuits 34 indicated by A, B, C and D may be mixedly arranged along the longitudinal direction of the substrate 18. The number of series circuits 34 on which the LEDs 19 are mixedly arranged along the longitudinal direction of the substrate 18 may be three or five or more besides two and four.

The LED module 11 according to a fourth embodiment is shown in FIG. 6. Explanation of components and action and effects same as those in the embodiments explained above is omitted.

The LEDs 19 are arranged, for example, in two rows in a direction crossing the longitudinal direction of the substrate 18, i.e., the latitudinal direction of the substrate 18. The LEDs 19 of the series circuits 34 indicated by A are continuously arranged in one row along the longitudinal direction of the substrate 18. The LEDs 19 of the series circuits 34 indicated by B are continuously arranged in the other row along the longitudinal direction of the substrate 18. The LEDs 19 in one row and the LEDs 19 in the other row are arranged to be shifted by a half pitch in the longitudinal direction of the substrate 18.

In the longitudinal direction of the substrate 18, the LEDs 19 indicated by A and the LEDs 19 indicated by B are alternately arranged. Therefore, in this embodiment, as in the embodiments explained above, the LEDs 19 of the plurality of series circuits 34 are mixedly arranged along the longitudinal direction of the substrate 18.

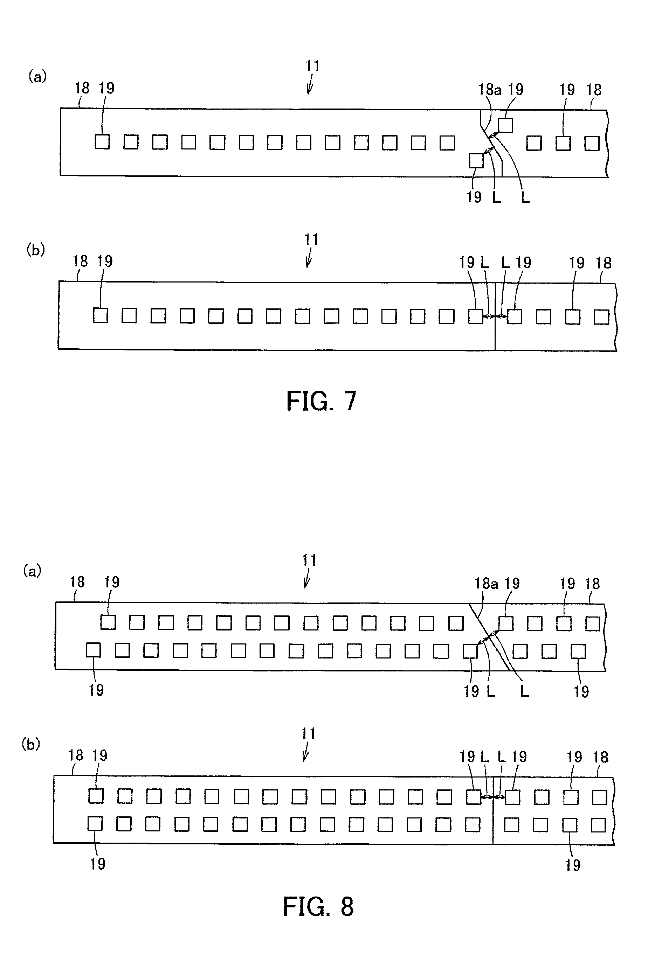

The LED module 11 according to a fifth embodiment is shown in FIGS. 7A and 7B. Explanation of components and action and effects same as those in the embodiments explained above is omitted.

In the LED module 11, the plurality of substrates 18 mounted with the LEDs 19 are connected along the longitudinal direction of the LED module 11. A predetermined distance L needs to be set between the ends in the longitudinal direction of the substrates 18 and the LEDs 19 in order to secure insulation properties of the LED 19 and limit mounting of the LEDs 19 according to a mounting method.

As indicated by a comparative example shown in FIG. 7(b), if the end of the substrate 18 is perpendicular to the longitudinal direction of the substrate 18, a distance equivalent to 2L is set between the LEDs 19 in a connected portion of the substrates 18 adjacent to each other. The distance 2L is sometimes larger than a distance between the LEDs 19 mounted on each of the substrates 18 along the longitudinal direction. In this case, since the LEDs 19 in the longitudinal direction of the substrates 18 are spaced apart in the connected portion of the substrates 18, a dark portion is formed.

As shown in FIG. 7(a), in this embodiment, a joining section 18a inclined at, for example, 45° with respect to the longitudinal direction of the substrates 18 is formed. The LEDs 19 at the ends are mounted in positions spaced with the distance L apart from the joining section 18a. Further, the LED 19 at the end of each of the substrates 18 is arranged to be shifted to the end side of each of the substrates 18 along the inclination of the joining section 18a, i.e., in the latitudinal direction of the substrate 18. Consequently, even in the connected portion of the substrates 18, the LEDs 19 are arranged at substantially equal pitches along the longitudinal direction of the substrate 18. It is possible to prevent a dark portion from being formed.

The LED module 11 according to a sixth embodiment is shown in FIGS. 8(a) and 8(b). Explanation of components and action and effects same as those in the embodiments explained above is omitted.

In the LED module 11, the LEDs 19 are arranged in two rows in a direction crossing the longitudinal direction of the substrate. In this case, as in the fifth embodiment, the predetermined distance L needs to be set between the end in the longitudinal direction of the substrate 18 and the LED 19 in each of the rows.

As indicated by a comparative example shown in FIG. 8(b), if the end of the substrate 18 is perpendicular to the longitudinal direction of the substrates 18, a distance equivalent to 2L is set between the LEDs 19 in a connected portion of the substrates 18 adjacent to each other. The distance 2L is sometimes larger than a distance between the LEDs 19 mounted on each of the substrates 18 along the longitudinal direction. In this case, since the LEDs 19 in the longitudinal direction of the substrates 18 are arranged with spaces in the connected portion of the substrates 18, a dark portion is formed.

As shown in FIG. 8(a), in this embodiment, the joining section 18a inclined at, for example, 45° with respect to the longitudinal direction of the substrates 18 is formed. The LEDs 19 at the ends of each of the rows are mounted in positions spaced the distance L apart from the joining section 18a. Further, the LEDs 19 in one row and the LEDs 19 in the other row are arranged to be shifted in the longitudinal direction of the substrate 18. Consequently, in the connected portion of the substrates 18, a space between the LED 19 in one row of one substrate 18 and the LED 19 in the other row of the other substrate 18 in the longitudinal direction of the substrate 18 is narrowed. It is possible to prevent a dark portion from being formed.

The LED module 11 can be applied not only to the tube type lamp 10 but also to a luminaire in which the LED module 11 is attached to a luminaire main body.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

## Claims

1. An LED module (11) comprising:
a substrate (18); and
a connection circuit (33) including at least two series circuits (34), in each of which a plurality of LEDs (19) are connected in series,
the LEDs (19) of the series circuits (34) different from one another being mixedly arranged along a longitudinal direction of the substrate (18).

2. The module (11) according to claim 1, wherein the LED (19) of the different series circuit (34) is arranged adjacent to each of the LEDs (19) of each of the series circuits (34).

3. The module (11) according to claim 1 or 2, wherein
the connection circuit (33) includes at least two series circuit groups (35) in which a plurality of the series circuits (34) are connected in parallel,
the series circuit groups (35) are connected in series,
and
the LEDs (19) of the different series circuits (34) are mixedly arranged along the longitudinal direction of the substrate (18) in each of the series circuit groups (35).

4. The module (11) according to claim 1 or 2, wherein
one end side in the longitudinal direction of the substrate (18) is connected to a positive electrode and a negative electrode of a direct-current power supply,
the connection circuit (33) includes at least two series circuit groups (35) in which a plurality of the series circuits (34) are connected in parallel,
a plurality of the series circuit groups (35) are connected in series between the positive electrode and the negative electrode of the direct-current power supply, and
the LEDs (19) of the series circuit group (35) close to the positive electrode side of the direct-current power supply and the LEDs (19) of the series circuit group (35) close to the negative electrode side of the direct-current power supply are mixedly arranged along the longitudinal direction of the substrate (18).

5. The module (11) according to claim 3 or 4, wherein the module (11) includes a plurality of the substrates (18),
the plurality of the substrates (18) are connected along the longitudinal direction, and
the series circuit group (35) is provided on each of the substrates (18).

6. The module (11) according to claim 5, wherein a joining section (18a) inclined with respect to the longitudinal direction of the substrate (18) is formed at ends in the longitudinal direction of the substrates (18) connected to each other.

7. A tube type lamp (10) comprising:
the LED module (11) according to any one of claims 1 to 6;
a translucent cover (13) of a tube type in which the LED module (11) is housed;
a cap for power supply (14) attached to one end of the translucent cover (13); and
a cap for non-power supply (15) attached to the other end of the translucent cover (13).

8. A luminaire (27) comprising:
the tube type lamp (10) according to claim 7; and
a luminaire main body (28) in which the tube type lamp (10) is arranged.
